# EUROPEAN PATENT APPLICATION

(11) **EP 4 307 337 A2**
(43) Date of publication of application: **17.01.2024**
(21) Application number: 23175667.7
(22) Date of filing: 26.05.2023
(51) Int. Cl.: H01J 37/317, H01J 37/30, H01J 37/302

(54) **DRAWING APPARATUS, DRAWING METHOD, AND METHOD OF MANUFACTURING PLATE**

(30) Priority: 21.06.2022 JP 2022099937
(71) Applicant: Kioxia Corporation, Tokyo 105-0023 (JP)
(72) Inventor: Kagawa, Yoshinori, Tokyo, 105-0023 (JP)
(74) Representative: Marks & Clerk LLP

(57) **Abstract**

In one embodiment, a drawing apparatus includes a drawer configured to draw a pattern on a plurality of regions with a beam, an operator configured to transfer data for irradiating the plurality of regions with the beam, and a controller configured to control the drawing on the plurality of regions with the drawer, based on the data for the plurality of regions transferred from the operator. When performing the drawing on a first region and then the drawing on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

## Description

### FIELD

Embodiments described herein relate to a drawing apparatus, a drawing method, and a method of manufacturing a plate.

### BACKGROUND

When an electron beam draws a pattern on a substrate, the drawing may be temporarily stopped between starting of drawing and completion of drawing. In this case, beam drift may disadvantageously occur in which positions to be irradiated with electron beams deviate from a predetermined position.

### BRIEF DESCRIPTION OF THE DRAWINGS

FIG. 1 is a schematic diagram showing a structure of a drawing apparatus of a first embodiment;
FIGS. 2A to 2D are a cross-sectional views for explaining a method of manufacturing a photomask of the first embodiment;
FIGS. 3A and 3B are a layout diagram and a graph for explaining a drawing method of the first embodiment;
FIGS. 4A to 4C are layout diagrams for explaining examples of drawing patterns of the first embodiment;
FIGS. 5A and 5B are diagrams for explaining operation of a drawing apparatus of a comparative example of the first embodiment;
FIGS. 6A and 6B are diagrams for explaining operation of the drawing apparatus of the first embodiment;
FIGS. 7A and 7B are diagrams for explaining operation of the drawing apparatus of a second embodiment;
FIGS. 8A and 8B are diagrams for explaining operation of the drawing apparatus of a third embodiment; and
FIGS. 9A to 9C are diagrams for explaining operation of the drawing apparatus of a fourth embodiment.

### DETAILED DESCRIPTION

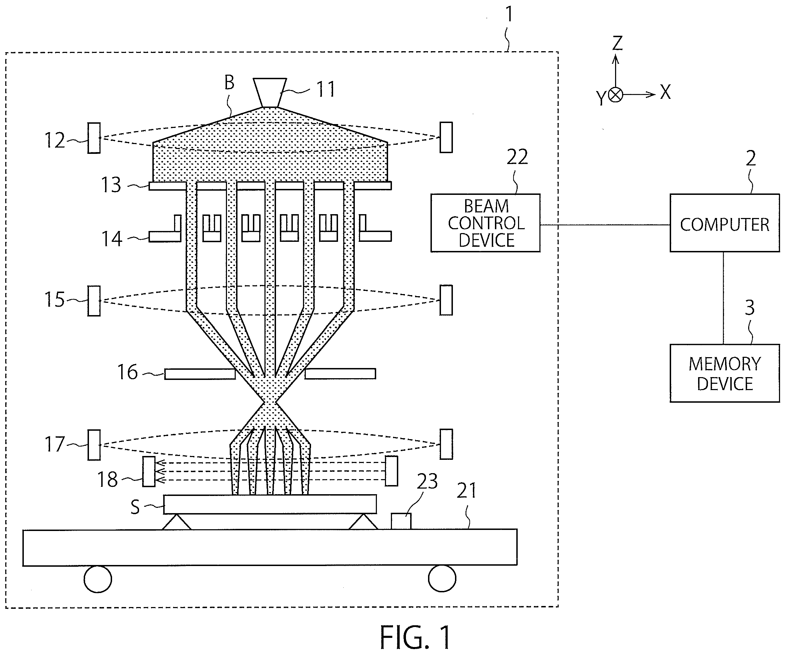

Embodiments will now be explained with reference to the accompanying drawings. In FIGS. 1 to 9C, the same configurations are denoted by the same reference numerals and characters, and duplicate descriptions are omitted.

In one embodiment, a drawing apparatus includes a drawer configured to draw a pattern on a plurality of regions with a beam, an operator configured to transfer a data for irradiating the plurality of regions with the beam, and a controller configured to control the drawing on the plurality of regions with the drawer, based on the data for the plurality of regions transferred from the operator. When performing the drawing on a first region and then the drawing on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

### (First Embodiment)

FIG. 1 is a schematic diagram showing a structure of a drawing apparatus of a first embodiment. The drawing apparatus of the present embodiment is, for example, an electron beam (EB) drawing apparatus that draws a pattern on a substrate S with electron beams B. As is to be described below, the substrate S includes a resist film, and the electron beams B draws a pattern on the resist film.

The drawing apparatus of the present embodiment includes a main body 1, a computer 2, and a memory device 3. The main body 1 includes an electron gun 11, a focusing lens 12, a shaping aperture array member 13, a beam blanking electrode array 14, a projection lens 15, a limiting aperture member 16, an objective lens 17, a deflector 18, a stage 21, a beam control device 22, and a reference mark 23. The main body 1 is an example of a drawer. The computer 2 is an example of an operator. The beam control device 22 is an example of a controller and a determiner.

The main body 1 includes various hardware for drawing a pattern on the substrate S with the electron beams B. FIG. 1 shows X, Y, and Z directions which are perpendicular to each other as directions for indicating the orientation of the main body 1. In this specification, the +Z direction is defined as an upward direction, and the -Z direction is defined as a downward direction. The -Z direction may be the same as the gravity direction, or may not be the same as the gravity direction. In FIG. 1, the surface of the substrate S is parallel to the X and Y directions and perpendicular to the Z direction.

The computer 2 generates shot data for irradiating the substrate S with the electron beams B from drawing data for drawing a pattern on the substrate S, and transfers the shot data to the main body 1. The shot data is generated by dividing drawing data into shots. The main body 1 draws with the shot data transferred from the computer 2.

The memory device 3 stores various information such as drawing data. The computer 2 reads drawing data from the memory device 3 and generates shot data from the read drawing data.

The electron gun 11 generates an electron beam B. The focusing lens 12 focuses the electron beam B generated by the electron gun 11. The shaping aperture array member 13 includes a plurality of apertures (aperture array) that shape the electron beam B having passed through the focusing lens 12. The beam blanking electrode array 14 includes a plurality of electrodes (electrode array) that blank electron beams B having passed through the shaping aperture array member 13. The projection lens 15 projects the electron beams B having passed through the beam blanking electrode array 14. The limiting aperture member 16 includes an aperture that changes the shape and size of the electron beams B having passed through the projection lens 15. The objective lens 17 focuses the electron beams B having passed through the limiting aperture member 16. The deflector 18 deflects the electron beams B having passed through the objective lens 17 to control the passing position and path of the electron beams B. The substrate S is irradiated with the electron beams B deflected by the deflector 18.

The stage 21 supports the substrate S below the electron gun 11. The substrate S placed on the stage 21 is irradiated with the electron beams B generated by the electron gun 11. Further, the stage 21 can move in the X and Y directions to control the position of the substrate S in the X and Y directions. This makes it possible to control positions to be irradiated with the electron beams B on the substrate S. The positions to be irradiated with the electron beams B with respect to the substrate S can also be controlled by the deflector 18.

The beam control device 22 performs various kinds of control on the electron beams B. For example, the beam control device 22 controls generation timings, shapes, sizes, passing positions, paths, irradiation positions, etc. of the electron beams B. Such control is performed by controlling the positions and operations of the electron gun 11, the shaping aperture array member 13, the beam blanking electrode array 14, the limiting aperture member 16, the deflector 18, the stage 21, and the like. The beam control device 22 performs such control based on shot data transferred from the computer 2. Thereby, the substrate S is irradiated with the electron beams B based on the shot data, so that a desired pattern is drawn on the substrate S. Further details of the beam control device 22 are described below.

The reference mark 23 is a mark to be used for detecting beam drift of the electron beams B. Beam drift is a phenomenon in which the positions to be irradiated with the electron beams B deviate from a desired position. The reference mark 23 of the present embodiment is disposed on the stage 21 and has a cross shape in a plan view. Beam drift occurs, for example, due to the drawing apparatus or the substrate S being charged. Beam drift may lower accuracy of the positions to be irradiated with the electron beams B.

The drawing apparatus of the present embodiment scans the reference mark 23 with the electron beams B and calculates the amount of positional deviation between the reference mark 23 and the electron beams B, thereby detecting positional deviation due to beam drift. Then, the drawing apparatus of the present embodiment performs beam drift correction for correcting the amount of positional deviation to a proper value. This makes it possible to keep high accuracy of the positions to be irradiated with the electron beams B. The drawing apparatus of the present embodiment performs beam drift correction periodically during drawing in order to prevent accuracy deterioration due to temporal change in the electron beam B. Beam drift correction is controlled by the beam control device 22.

In the present embodiment, for example, photomasks to be used in lithography in manufacturing semiconductor devices is manufactured from the substrate S. Alternatively, a template for nanoimprinting may be manufactured from the substrate S. These photomasks and templates are examples of plates. Furthermore, the drawing apparatus of the present embodiment may draw with beams other than electron beams B, for example, charged particle beams using charged particles other than electrons.

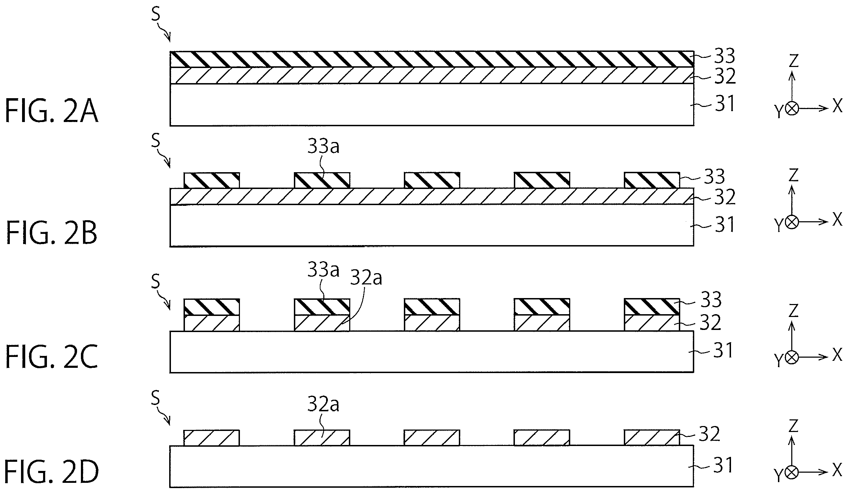

FIGS. 2A to 2D are cross-sectional views for explaining a method of manufacturing a photomask of the first embodiment.

First, a substrate S including a translucent substrate 31, a light shielding layer 32, and a resist film 33 is prepared (FIG. 2A). In FIG. 2A, the light shielding layer 32 is provided on the translucent substrate 31, and the resist film 33 is provided on the light shielding layer 32. The translucent substrate 31 is, for example, a glass substrate, or a quartz substrate. The light shielding layer 32 is, for example, a chromium (Cr) layer.

Next, the drawing apparatus of the present embodiment draws a pattern on the resist film 33, and then develops the resist film 33 (FIG. 2B). As a result, a resist pattern 33a is formed from the resist film 33 based on the pattern drawn on the resist film 33. In FIG. 2B, drawing is performed by placing the translucent substrate 31 on the stage 21 and irradiating the resist film 33 with the electron beams B.

Next, the resist film 33 is used as an etching mask, and the light shielding layer 32 is processed (FIG. 2C). As a result, the resist pattern 33a is transferred to the light shielding layer 32 and a light shielding pattern 32a is formed from the light shielding layer 32. The light shielding layer 32 is processed, for example, by dry etching such as reactive ion etching (RIE) or wet etching with a chemical solution.

Next, the resist film 33 is removed (FIG. 2D). The photomask is manufactured from the substrate S in this manner.

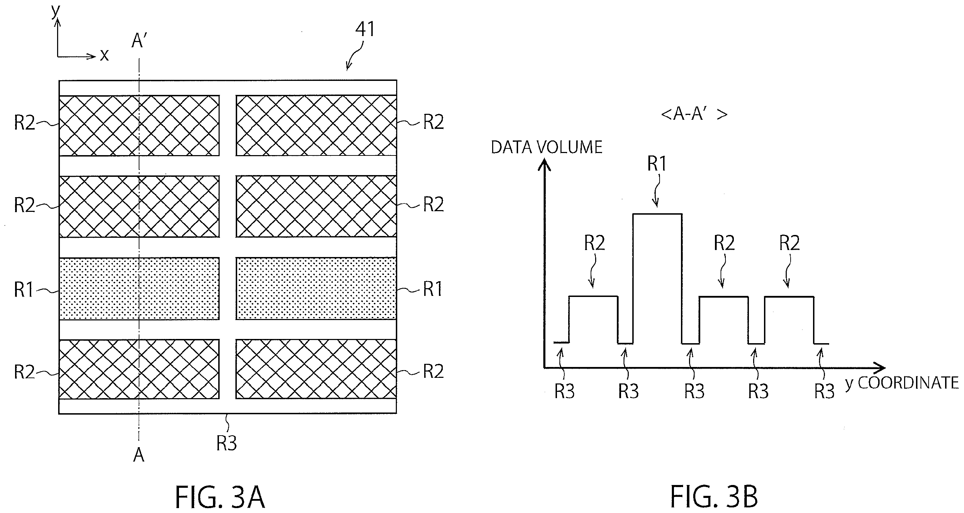

FIGS. 3A to 3B are a layout diagram and a graph for explaining the drawing method of the first embodiment.

FIG. 3A shows an example of a layout indicated by the drawing data in the memory device 3. The drawing apparatus of the present embodiment draws a pattern on a drawing region of the substrate S with the electron beams B. A region 41 shown in FIG. 3A is a region on the data included in the drawing data and corresponds to the drawing region of the substrate S. Therefore, the figure shown in the region 41 is drawn as a pattern in the drawing region of the substrate S. Hereinafter, the region 41 is to be referred to as a "drawing region 41" for easier understanding of the description. As described above, the drawing region 41 is not an actual drawing region of the substrate S, but the drawing region on the data included in the drawing data. An x direction and a y direction shown in FIG. 3A respectively correspond to the X direction and the Y direction shown in FIG. 1. Further, the pattern to be drawn by the electron beams B in the drawing region of the substrate S is called a "drawing pattern".

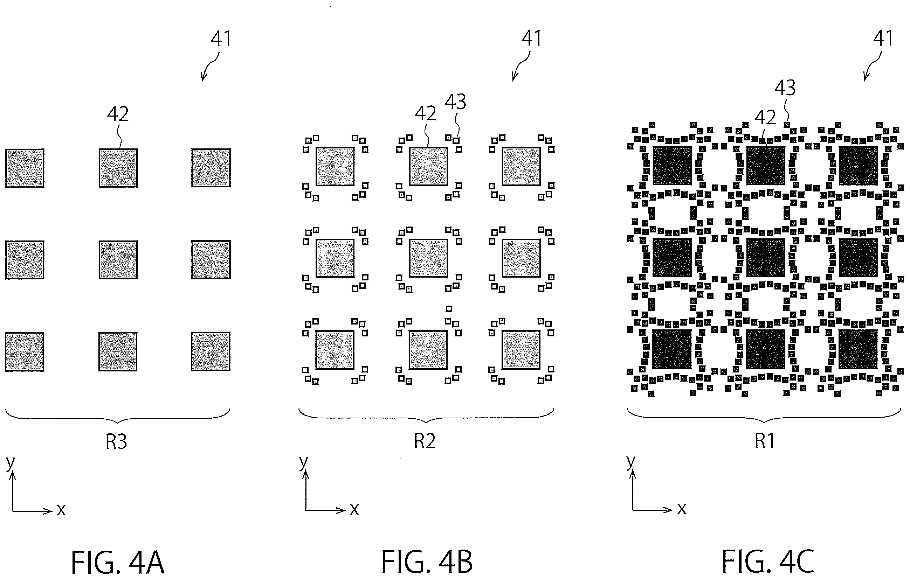

In FIG. 3A, the drawing region 41 includes two regions R1, six regions R2, and one region R3 sandwiched between these regions R1 and R2. Each of these regions R1, R2, and R3 includes a plurality of figures to be drawing patterns. The numbers of these figures per unit area are great in each region R1 (high figure number region), medium in each region R2 (medium figure number region), and low in the region R3 (low figure number region). Examples of these regions R1, R2, and R3 are shown in FIG. 4 to be described below.

FIG. 3B shows data volume (data capacity) per unit area of each location in the drawing region 41 along the line A-A' shown in FIG. 3A. In general, data volume of drawing data becomes large in a location having many figures per unit area. Therefore, in FIG. 3B, the data volume in the region R1 is large, the data volume in the region R2 is medium, and the data volume of the region R3 is small.

As is to be described below, drawing data having a large data volume may consume a long time to generate and transfer shot data. As a result, the shot data does not reach the main body 1 (beam control device 22) from the computer 2 at a desired timing. This may generate a data path wait (transfer wait) from the computer 2 to the beam control device 22 during drawing. Details of the data path wait are to be described below.

FIG. 4A to 4C are layout diagrams for explaining examples of drawing patterns of the first embodiment.

FIGS. 4A, 4B, and 4C show layout examples of the regions R3, R2, and R1, respectively. Each of these regions R1, R2, and R3 includes a plurality of large figures 42. In contrast, the region R3 contains no small figures 43, the region R2 contains only a few small figures 43, and the region R1 contains many small figures 43. As a result, the numbers of figures 42 and 43 per unit area are large in the region R1, medium in the region R2, and small in the region R3. The figures 43 may be figures with what is known as a sub-resolution assist feature (SRAF) pattern.

The following describes operation of a drawing apparatus of a comparative example of the first embodiment, and then operation of the drawing apparatus of the first embodiment. The reference numerals and characters shown in FIG. 1 are used not only in description on the drawing apparatus of the first embodiment, but also in description on the drawing apparatus of the comparative example.

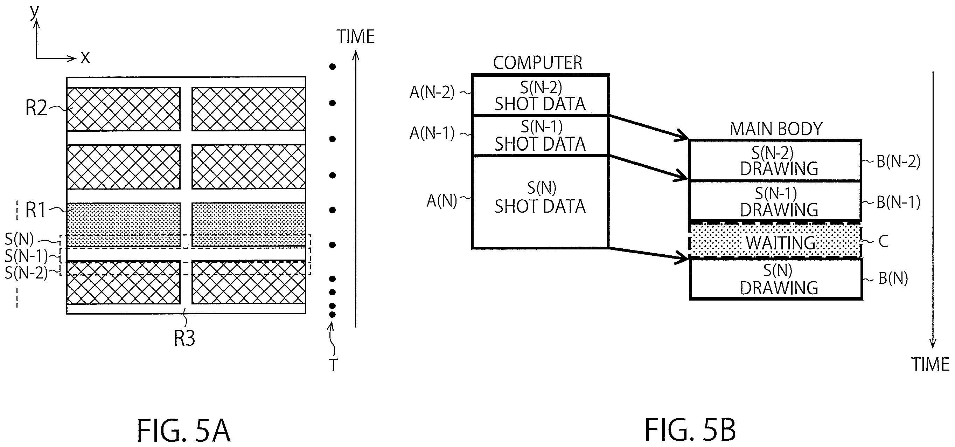

FIGS. 5A to 5B are diagrams for explaining operation of the drawing apparatus of the comparative example of the first embodiment.

FIG. 5A shows an example of a layout indicated by the drawing data of this comparative example. The layout shown in FIG. 5A is the same as the layout shown in FIG. 3A. Therefore, the drawing region 41 shown in FIG. 5A includes two regions R1 (high figure number region), six regions R2 (medium figure number region), and one region R3 (low figure number region).

The drawing apparatus of this comparative example divides the drawing region of the substrate S into a plurality of stripes, and draws a pattern on the drawing region of the substrate S for each stripe. These stripes are formed by dividing the drawing region of the substrate S in the Y direction. Therefore, each stripe is a region extending in the X direction. The Y direction is an example of a predetermined direction. The drawing apparatus of this comparative example sequentially draws patterns on these stripes.

The regions "S(N-2)", "S(N-1)", and "S(N)" shown in FIG. 5A are regions on the data included in the drawing data, and correspond to a plurality of stripes formed by dividing the drawing region ("N" is a positive integer). The character "N" represents an order in which the pattern is drawn on the respective stripes. Therefore, these stripes are drawn in the order of "S(N-2)", "S(N-1)", "S(N)". In the following description, these regions "S(N-2)", "S(N-1)" and "S(N)" are referred to as "stripes S(N-2), S(N-1) and S(N)". As described above, these stripes "S(N-2)", "S(N-1)", "S(N)" are not actual stripes on the substrate S, but stripes on the data contained in the drawing data. The stripes of this comparative example further include stripes drawn before stripe "S(N-2)" and stripes drawn after stripe "S(N)". These stripes are examples of a plurality of regions on which patterns are drawn with the beams.

As described above, shot data is generated by dividing drawing data into shots. The shot data is generated for each stripe. For example, the drawing pattern for stripe "S(N-2)" is drawn with the shot data for stripe "S(N-2)", the drawing pattern of the stripe "S(N-1)" is drawn with the shot data for the stripe "S(N-1)", The drawing pattern of the stripe "S(N)" is drawn with the shot data for the stripe "S(N)".

FIG. 5A also indicates timings at which beam drift corrections are performed on the drawing apparatus of this comparative example, with black circles that are indicated by an arrow T. In this comparative example, the drawing apparatus starts drawing, then has a first beam drift correction performed one minute after starting of drawing, a second beam drift correction performed two minutes after the first beam drift correction, and a third beam drift correction performed three minutes after the second beam drift correction. A "Ka"th beam drift correction ("Ka" is an integer of 2 to 12) is performed "Ka" minutes after a "Ka-1"th beam drift correction. After that, a "Kb"th beam drift correction ("Kb" is an integer of 13 or more) is performed 12 minutes after a "Kb-1"th beam drift correction. In other words, beam drift correction intervals in this comparative example are from 1 minute to 12 minutes in increments of 1 minute, and then are constant at 12 minutes.

What are described with reference to FIG. 5A are similarly applied to the first embodiment and the second to fourth embodiments to be described below.

FIG. 5B shows timings at which computer 2 generates and transfers shot data for stripes "S(N-2)", "S(N-1)", and "S(N)", and timings at which the main body 1 performs drawing for the stripes "S(N-2)", "S(N-1)", and "S(N)". In FIG. 5B, the direction in which time advances is indicated by a downward arrow.

In FIG. 5B, boxes "A(N-2)", "A(N-1)", and "A(N)" respectively show timings at which computer 2 generates and transfers shot data for the stripes "S(N-2)", "S(N-1)", and "S(N)". A start point of an arrow extending from the box "A(N-2)" indicates the timing at which the computer 2 starts transferring the shot data for the stripe "S(N-2)" to the beam control device 22; an end point of the arrow extending from the box "A(N-2)" indicates the timing at which the computer 2 completes transferring the shot data for the stripe "S(N-2)" to the beam control device 22. This is the same for an arrow extending from a box "A(N-1)" and an arrow extending from "box A(N)".

In FIG. 5B, boxes "B(N-2)", "B(N-1)", and "B(N)" respectively indicate timings at which the main body 1 performs drawing for the stripes "S(N-2)", "S(N-1)", and "S(N)" The upper side of the box "B(N-2)" indicates the timing at which drawing for the stripe "S(N-2)" is started; The lower side of the box "B(N-2)" indicates the timing at which the drawing for the stripe "S(N-2)" is completed; The same applies to the upper and lower sides of the box "B(N-1)" and the upper and lower sides of the box "B(N)". Drawing for the stripes "S(N-2)", drawing for "S(N-1)", and drawing for "S(N)" are respectively started at timings at which transfer of shot data for the stripe "S(N-2)", "S(N-1)", and "S(N)" are completed, and the respective drawing are completed thereafter. A box "C" indicates that a data path wait occurs between completion of drawing for the stripe "S(N-1)" and starting of drawing for the stripe "S(N)".

Here, the problems of this comparative example are to be explained.

As shown in FIG. 5A, most of the stripe "S(N-2)" is located in the region R2, the stripe "S(N-1)" is located in the region R3, most of the stripe "S(N)" is located in the region R1. Therefore, the shot data for the stripe "S(N)" contains many figures per unit area, and the data volume is large.

In FIG. 5B, the vertical width (that is, time) of a box "A(N)" is longer than the vertical width of the box "A(N-2)" and the vertical width of the box "A(N-1)". This indicates that the volume of the shot data for the stripe "S(N)" is larger and it takes a long time to generate and transfer the shot data. As a result, the shot data does not reach the beam control device 22 from the computer 2 before drawing for the stripe "S(N-1)" is completed, so that a data path wait occurs before starting of drawing for the stripe "S(N)". In FIG. 5B, the timing at which drawing for the stripe "S(N-1)" is completed precedes the timing at which transfer of shot data for the stripe "S(N)" is completed. In other words, the timing indicated by the lower side of the box "B(N-1)" precedes the timing indicated by the end point of the arrow from the box "A(N)" (the upper side of "box B(N)").

During the data path wait, the drawing apparatus of this comparative example blanks the electron beams B with the beam blanking electrode array 14 to prevent the electron beams B from reaching the substrate S, and thereby temporarily stops drawing. In other words, blanking causes a wait time for drawing. This causes beam drift of the electron beams B to occur. For example, the drawing apparatus and the substrate S may be charged due to the blanked electron beams B, causing beam drift of the electron beams B to occur. As a result, when drawing for the stripe "S(N)" is subsequently performed, the positions to be irradiated with the electron beams B may shift from the desired position.

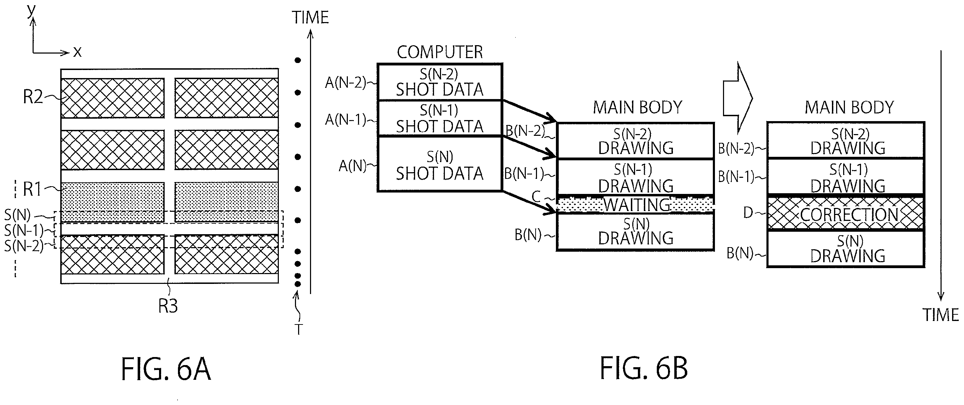

FIGS. 6A to 6B are diagrams for explaining operation of the drawing apparatus of the first embodiment.

FIG. 6A shows an example of a layout indicated by drawing data of the present embodiment, similarly to FIG. 3A and FIG. 5A. The layout shown in FIG. 6A is the same as the layouts shown in FIGS. 3A and 5A.

Similarly to FIG. 5B, FIG. 6B shows timings at which computer 2 generates and transfers shot data for the stripes "S(N-2)", "S(N-1)", and "S(N)", and timings at which the main body 1 performs drawing for the stripes "S(N-2)", "S(N-1)", and "S(N)". However, when the drawing apparatus of the present embodiment expects that drawing timings on the left shown in FIG. 6B occur, the drawing apparatus uses drawing timings on the right shown in FIG. 6B instead. A white arrow shown in FIG. 6B indicates replacement from the drawing timings on the left to the drawing timings on the right shown in FIG. 6B. A box "D" shows that beam drift correction is performed between completion of drawing for the stripe "S(N-1)" and starting of drawing for the stripe "S(N)". The stripes "S(N-1)", and "S(N)" are respectively examples of first and second regions (more precisely, the actual stripes on the substrate S corresponding to the stripes "S(N-1)", and "S(N)" on the data). Further details of the drawing timings on the left and right shown in FIG. 6B are described below.

The drawing timings on the left shown in FIG. 6B are the same as the drawing timings shown in FIG. 5B except the sizes of the box A(N) and the box "C". With this drawing timings, the box "C" shown in FIG. 6B indicates that a data path wait occurs between completion of drawing for the stripe "S(N-1)" and starting of drawing for the stripe "S(N)". This data path wait occurs because it takes a long time to generate and transfer the shot data for the stripe "S(N)".

Then, the beam control device 22 (FIG. 1) of the present embodiment determines whether transfer of the shot data for the stripe "S(N)" is incomplete when drawing for the stripe "S(N-1)" is completed. In other words, it is determined whether the timing indicated by the end point of an arrow from a box "A(N)" (upper side of box "B(N)") succeeds the timing indicated by the lower side of box "B(N-1)". For example, the beam control device 22 detects that it has not yet received all the shot data for the stripe "S(N)", so that the beam control device 22 can detect that transfer of the shot data for the stripe "S(N)" has not been completed. Furthermore, for example, the beam control device 22 detects that it has already performed entire drawing for the stripe "S(N-1)", so that the beam control device 22 can detect that drawing for the stripe "S(N-1)" has been completed.

If it is determined that transfer of shot data for the stripe "S(N)" is incomplete when drawing for the stripe "S(N-1)" is completed, the beam control device 22 uses the drawing timings on the right shown in FIG. 6B. In other words, the drawing apparatus of the present embodiment performs beam drift correction before drawing for the stripe "S(N)" is started under control of the beam control device 22. Beam drift correction is indicated by the box "D" and is performed separately from beam drift correction indicated by the black circles in FIG. 6A. In this case, drawing for the stripe "S(N)" is performed after beam drift correction shown in the box "D" is completed. Beam drift correction is an example of correcting a state of the drawer.

The above-described determination is similarly performed on other stripes. For example, if it is determined that transfer of shot data for the stripe "S(N-1)" is incomplete when drawing for the stripe "S(N-2)" is completed, beam drift correction is performed before drawing for the stripe "S(N-1)" is started.

As described above, the drawing apparatus of the present embodiment uses the drawing timings on the right shown in FIG. 6B instead of the drawing timings on the left shown in FIG. 6B. Therefore, the present embodiment makes it possible to prevent problems involved in stopping of drawing. For example, if drawing is temporarily stopped by blanking the electron beams B during a data path wait, beam drift of the electron beam B may occur. The present embodiment makes it possible to prevent the drawing stops from being a cause of beam drift by performing beam drift correction instead during the drawing stops.

### (Second Embodiment)

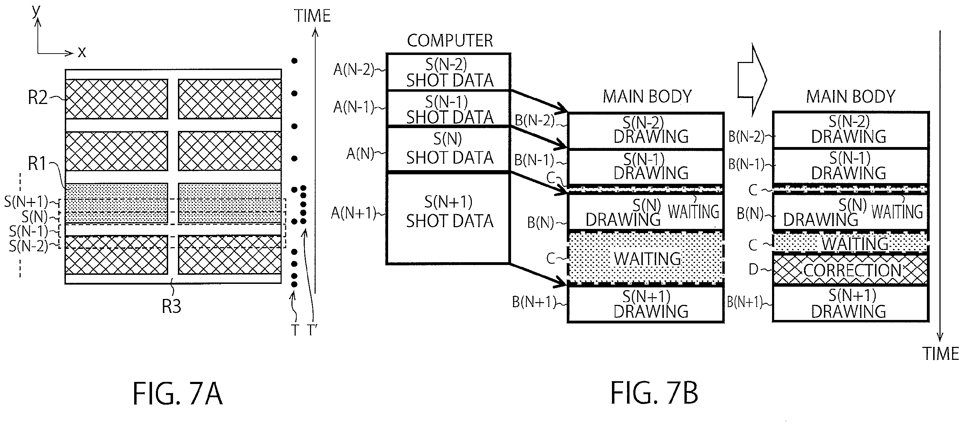

FIGS. 7A to 7B are diagrams for explaining operation of a drawing apparatus of a second embodiment. A structure of the drawing apparatus of the present embodiment is as shown in FIG. 1, and similar to the drawing apparatus of the first embodiment.

FIG. 7A, similarly to FIG. 6A, shows an example of a layout indicated by drawing data of the present embodiment. The layout shown in FIG. 7A is the same as the layout shown in FIG. 6A and the like. However, FIG. 7A shows a stripe "(N+1)" in addition to the stripes "S(N-2)", "S(N-1)", and "S(N)". Most of the stripe "S(N+1)", similar to the stripe "S(N)", is located in a region R1. Therefore, shot data for the stripe "S(N+1)" contains many figures per unit area, and the data volume is large.

Similarly to FIG. 6B, FIG. 7B shows timings at which computer 2 generates and transfers shot data for the stripes "S(N-2)", "S(N-1)", "S(N)", and "S(N+1)" and timings at which the main body 1 performs drawing for the stripes "S(N-2)", "S(N-1)", "S(N)", "S(N+1)". However, when the drawing apparatus of the present embodiment expects that drawing timings on the left shown in FIG. 7B occur, the drawing apparatus uses drawing timings on the right shown in FIG. 7B instead. A box "D" shown in FIG. 7B shows that beam drift correction is performed between completion of drawing for the stripe "S(N)" and starting of drawing for the stripe "S(N+1)". In FIG. 7B, the stripes "S(N)", and "S(N+1)" are respectively examples of first and second regions (more precisely, the actual stripes on the substrate S corresponding to the stripes "S(N)", and "S(N+1)" on the data). FIG. 7B further shows boxes "A(N+1)", "B(N+1)" corresponding to the stripe "S(N+1)". Further details of drawing timings on the left and the right shown in FIG. 7B are described below.

The drawing timings on the left shown in FIG. 7B includes a small box "C" between the stripe "S(N-1)" and the stripe "S(N)", and a large box "C" between the stripe "S(N)" and the stripe "S(N+1)". With this drawing timings, the small box "C" indicates that a short data path wait occurs between completion of drawing for the stripe "S(N-1)" and starting of drawing for the "stripe S(N)". With this drawing timings, the large box "C" indicates that a long data path wait occurs between completion of drawing for the stripe "S(N)" and starting of drawing for the "stripe S(N+1)". This is because the data volume of shot data for the stripe "S(N+1)" is larger than the data volume of shot data for the stripe "S(N)" and it takes a longer time to generate and transfer the shot data for the stripe "S(N+1)". In this case, a long data path wait, indicated by the large box "C", can cause large beam drift.

Then, the beam control device 22 (FIG. 1) of the present embodiment determines whether the drawing data includes shot data with a large data volume that causes a long data path wait indicated by the large box "C". For example, it is determined whether the data volume of shot data of each stripe is greater than a threshold. Alternatively, it may be determined whether the number of figures included in shot data of each stripe is greater than a threshold. In order to make such a determination, the drawing apparatus of the present embodiment registers the drawing data from the memory device 3 or the computer 2 into the beam control device 22 in advance before starting drawing. This enables the determination to be made in the beam control device 22. A condition in the determination is an example of a predetermined condition.

The drawing timings on the left shown in FIG. 7B includes the large box "C" between the stripe "S(N)" and the stripe "S(N+1)". This is due to the large data volume of shot data for the stripe "S(N+1)". Therefore, the beam control device 22 determines that the data volume of shot data for the stripe "S(N+1)" satisfies the above condition, or that the data volume is greater than threshold, and uses the drawing timings on the right shown in FIG. 7B. In this case, under control of the beam control device 22, the drawing apparatus of the present embodiment performs a short data path wait and a beam drift correction thereafter before starting drawing for the stripe "S(N+1)". In contrast, the small box "C" between the stripes "S(N-1)" and "S(N)" is not changed by the replacement from the drawing timings on the left to the drawing timings on the right shown in FIG. 7B. The reason is that the data volume of shot data for the stripe "S(N)" does not satisfy the above condition or that the data volume is smaller than the threshold.

The beam control device 22 may determine whether a wait time (data path wait) before completion of transferring shot data of each stripe is longer than a threshold. The drawing timings on the left shown in FIG. 7B include the box "C" with a long wait time between the stripe "S(N)" and the stripe "S(N+1)". Therefore, the beam control device 22 uses the drawing timings on the right shown in FIG. 7B also in this case.

FIG. 7A shows black circles indicated by an arrow T' in addition to black circles indicated by an arrow T. The black circles indicated by the arrow T' indicate an example of the timings of performing the above beam drift correction as a result of determination made by the beam control device 22. In FIG. 7A, shot data for the stripe in the region R1 has a large data volume, so that there are black circles, indicated by the arrow T' along the region R1.

As described above, the drawing apparatus of the present embodiment uses the drawing timings on the right shown in FIG. 7B instead of the drawing timings on the left shown in FIG. 7B. Therefore, the present embodiment, as in the first embodiment, makes it possible to prevent the problems involved in stopping of drawing. Furthermore, the present embodiment makes it possible to selectively replace a long data path wait, among a plurality of data path waits, with beam drift correction to efficiently perform drawing in spite of addition of beam drift correction. For example, the time required for drawing in the drawing timings on the right shown in FIG. 7B is the same as the time in the drawing timings on the left shown in FIG. 7B.

The drawing timings on the right shown in FIG. 7B may have a box "D" arranged before a box "C", instead of having a box "D" arranged after a box "C". In other words, the time between completion of drawing for the stripe "S(N)" and starting of drawing for the stripe "S(N+1)" may first have beam drift correction (box "D") and then a short data path wait (box "C"). However, it is desirable to perform beam drift correction immediately before drawing. So, as shown in FIG. 7B, it is more desirable to first perform a short data path wait (box "C") and then perform a beam drift correction (box "D").

### (Third Embodiment)

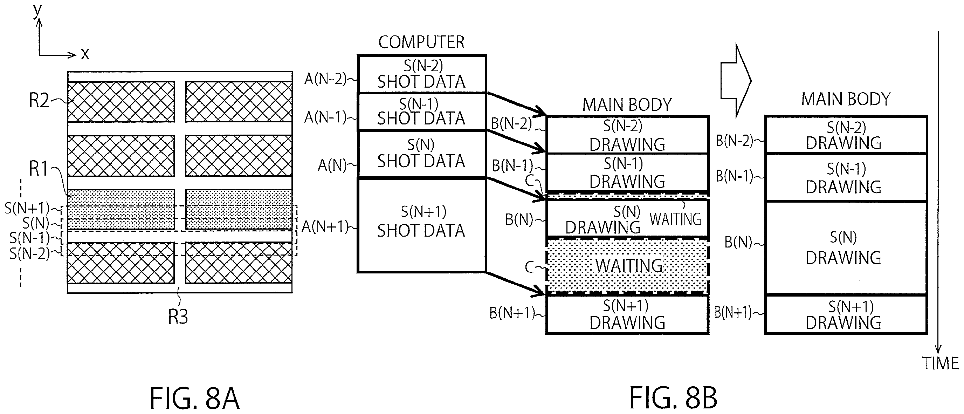

FIGS. 8A to 8B are diagrams for explaining operation of a drawing apparatus of a third embodiment. A structure of the drawing apparatus of the present embodiment is as shown in FIG. 1, and similar to the drawing apparatus of the first embodiment.

FIG. 8A, similarly to FIG. 7A, shows an example of a layout indicated by drawing data of the present embodiment. The layout shown in FIG. 8A is the same as the layout shown in FIG. 7A. Thus, FIG. 8A shows the stripe "(N+1)" in addition to the stripes "S(N-2)", "S(N-1)", and "S(N)".

Similarly to FIG. 7B, FIG. 8B shows timings at which computer 2 generates and transfers shot data for the stripes "S(N-2)", "S(N-1)", "S(N)", and "S(N+1)" and timings at which the main body 1 performs drawing for the stripes "S(N-2)", "S(N-1)", "S(N)", "S(N+1)". However, when the drawing apparatus of the present embodiment expects that drawing timings on the left shown in FIG. 8B occurs, the drawing apparatus uses drawing timings on the right shown in FIG. 8B instead. The drawing timings on the left shown in FIG. 8B include a data path wait indicated by box "C". In contrast, the drawing timings on the right shown in FIG. 8B do not include the data path wait indicated by box "C"; In FIG. 8B, the stripes "S(N-1)", and "S(N)" are respectively examples of first and second regions, and the stripes "S(N)" and "S(N+1)" are also respectively examples of first and second regions. Further details of drawing timings on the left and the right shown in FIG. 8B are described below.

The drawing timings on the left shown in FIG. 8B includes a small box "C" between the stripe "S(N-1)" and the stripe "S(N)", and a large box "C" between the stripe "S(N)" and the stripe "S(N+1)". The drawing timings on the left shown in FIG. 8B are the same as the drawing timings on the left shown in FIG. 7B

The beam control device 22 (FIG. 1) of the present embodiment determines whether the drawing data includes shot data with a large data volume that causes a data path wait indicated by a box "C". A method of this determination is the same as the determination in the second embodiment. However, while the determination of the second embodiment is to determine whether there is a large box "C", the determination of the present embodiment is to determine whether there is a box "C" regardless of the size of the box "C". The determination of the present embodiment can be performed with the data volume, the number of figures, or the wait time, as in the determination of the second embodiment. For example, it is determined whether the data volume of shot data of each stripe is larger than a threshold.

The drawing timings on the left shown in FIG. 8B includes boxes "C" between the stripe "S(N-1)" and the stripe "S(N)" and between the stripe "S(N)" and the stripe "S(N+1)". So, the beam control device 22 determines that the data volume of shot data for the stripe "S(N)" or the stripe "S(N+1)" satisfies the above condition, or that the data volume is larger than threshold, to use the drawing timings on the right shown in FIG. 8B.

The drawing timings on the right shown in FIG. 8B has a timing of completion of drawing for the stripe "S(N-1)" that is delayed until the timing of starting of drawing for the stripe "S(N)", and has a timing of completion of drawing for the stripe "S(N)" that is delayed until the timing of starting of drawing for the stripe "S(N+1)". As a result, two boxes "C" (data path waits) have been eliminated. This makes it possible to prevent beam drift from occurring due to data path waits. Such operation is controlled by the beam control device 22.

The delay of completion of drawing for the stripe "S(N)" shortens the time from completion of drawing for the stripe "S(N)" to starting of drawing for the stripe "S(N+1)". In FIG. 8B, completion of drawing for the stripe "S(N)" is delayed until starting of drawing for the stripe "S(N+1)", thereby shortening the above time to zero. In the present embodiment, completion of drawing for stripe "S(N)" may be delayed so that the above time is not shortened to zero. In this case, the same beam drift correction as in the second embodiment may be performed between completion of drawing for the stripe "S(N)" and starting of drawing for the stripe "S(N+1)". In other words, the "addition of box "D"" in the second embodiment and the "deletion of box "C"" in the third embodiment may be performed in combination. This is also the case when completion of drawing for the stripe "S(N-1)" is delayed.

As described above, the drawing apparatus of the present embodiment uses drawing timings on the right shown in FIG. 8B instead of drawing timings on the left shown in FIG. 8B. Therefore, the present embodiment, as in the first and second embodiments, makes it possible to prevent the problems involved in stopping of drawing. Furthermore, the present embodiment makes it possible to delay completion of drawing for a predetermined stripe to eliminate data path wait, to obtain the same effect as in the second embodiment without adding beam drift correction. For example, the time required for drawing in the drawing timings on the right shown in FIG. 8B is the same as the time in the drawing timings on the left shown in FIG. 8B, so that drawing is performed efficiently as in the second embodiment.

### (Fourth Embodiment)

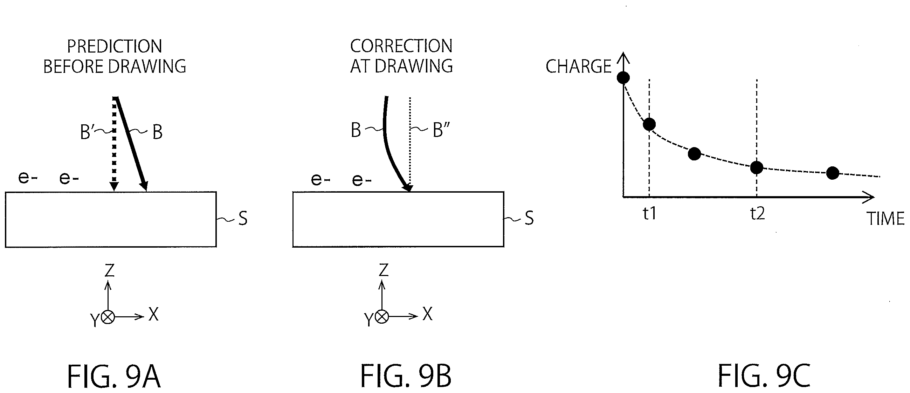

FIGS. 9A to 9C are diagrams for explaining operation of a drawing apparatus of a fourth embodiment. A structure of the drawing apparatus of the present embodiment is as shown in FIG. 1, and similar to the drawing apparatus of the first embodiment. The drawing apparatus of the present embodiment performs control shown in FIG. 6B of the first embodiment, FIG. 7B of the second embodiment, or FIG. 8B of the third embodiment.

FIG. 9A shows a prediction result of the position to be irradiated with an electron beam B. The beam control device 22 (FIG. 1) of the present embodiment predicts the position to be irradiated with the electron beam B when drawing a pattern on each stripe with the electron beams B before starting drawing. FIG. 9A shows how the surface of the substrate S (resist film) is charged. The position to be irradiated with the electron beam B is affected by such charge. FIG. 9A shows an ideal position to be irradiated with the electron beam B and the position to be irradiated with the electron beam B predicted by the beam control device 22. In order to distinguish one from the other, FIG. 9A indicates the electron beam B for the ideal irradiation position by "symbol B'".

The beam control device 22 predicts the position to be irradiated with the electron beam B when drawing a pattern on each stripe with the electron beam B, for example, based on shot data. In order to make such a prediction, the drawing apparatus of the present embodiment registers the drawing data from the memory device 3 or the computer 2 into the beam control device 22 in advance before starting drawing. The drawing data is also used when the "determination" described in the second or third embodiment is performed. The beam control device 22 predicts, for example, a charge amount of the substrate S based on shot data, and predicts the position to be irradiated with the electron beam B based on the prediction results of the charge amount of the substrate S and the like. Alternatively, the beam control device 22 may calculates a coverage of each stripe (ratio of the figure area to the total area in each stripe) based on the shot data, and may predict the position to be irradiated with the electron beam B based on the coverage of each stripe.

The beam control device 22 further corrects the position to be irradiated with the electron beam B during drawing, based on the prediction result of the position to be irradiated with the electron beam B (FIG. 9B). FIG. 9B shows the ideal position to be irradiated with the electron beam B and the position to be irradiated with the electron beam B corrected by the beam control device 22. In order to distinguish one from the other, FIG. 9B indicates the electron beam B for the ideal irradiation position by "symbol B"". The present embodiment makes it possible to correct the position to be irradiated with the electron beam B so as to be close to the ideal irradiation position. The beam control device 22 of the present embodiment determines what and how to correct the position to be irradiated with the electron beam B, in advance, before starting drawing. The beam control device 22 of the present embodiment is an example of a controller, a determiner, and a drawing operation corrector. The beam control device 22 of the present embodiment may predict and correct drawing operation other than drawing operation with respect to the position to be irradiated with the electron beam B.

The beam control device 22 predicts the position to be irradiated with the electron beam B in further consideration of the control indicated by FIG. 6B of the first embodiment, FIG. 7B of the second embodiment, or FIG. 8B of the third embodiment. For example, in a case in which a data path wait is replaced with a beam drift correction as in the first embodiment, the position to be irradiated with the electron beam B is predicted in consideration of the beam drift correction instead of the data path wait. The charge amount of the substrate S is reduced by this replacement. This makes it possible to improve the accuracy in prediction and correction of the position to be irradiated with the electron beam B.

FIG. 9C shows an example of change in the charge amount of the substrate S over time. The charge amount at time t1 indicates a calculated value of the charge amount during irradiation with the electron beam B in a case in which the replacement from data path wait to a beam drift correction is not taken into consideration. In contrast, the charge amount at time t2 indicates a calculated value of the charge amount during irradiation of the electron beam B in a case in which the replacement from the data path wait to the beam drift correction is taken into consideration. The present embodiment makes it possible to predict and correct the position to be irradiated with the electron beam B in consideration of the time decay of the charge amount of the substrate S (resist film).

As described above, the present embodiment makes it possible to apply the control of the first to third embodiments to a prediction and correction of the drawing operation of the drawing apparatus, to improve the accuracy in the prediction and correction of the drawing operation of the drawing apparatus.

While certain embodiments have been described, these embodiments have been presented by way of example only, and are not intended to limit the scope of the inventions. Indeed, the novel apparatuses and methods described herein may be embodied in a variety of other forms; furthermore, various omissions, substitutions and changes in the form of the apparatuses and methods described herein may be made without departing from the scope of the inventions.

Further aspects and embodiments are described below.

According to a first aspect there is provided a drawing apparatus comprising:
a drawer configured to draw a pattern on a plurality of regions with a beam;
an operator configured to transfer a data for irradiating the plurality of regions with the beam; and
a controller configured to control the drawing on the plurality of regions with the drawer, based on the data for the plurality of regions transferred from the operator, wherein
when performing the drawing on a first region and then the drawing on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

According to some embodiments, the plurality of regions are a plurality of stripes formed by dividing a drawing region in a predetermined direction.

According to some embodiments, the correction is beam drift correction of the drawer.

According to some embodiments the operator generates the data for irradiating the plurality of regions, from a data for pattern drawing on the plurality of regions.

According to some embodiments, the data for pattern drawing on the plurality of regions is a drawing data, and the data for irradiating the plurality of regions is a shot data.

According to some embodiments, the controller includes a determiner configured to determine whether the transfer of the data for the second region is incomplete when the drawing on the first region is completed, and
the controller corrects the state of the drawer before the drawing on the second region is started when the determiner determines that the transfer of the data for the second region is incomplete while the drawing on the first region is completed.

According to some embodiments, the controller includes a determiner configured to determine whether the data for the second region satisfies a predetermined condition, and
the controller corrects the state of the drawer before the drawing on the second region is started when the determiner determines that the data for the second region satisfies the predetermined condition.

According to some embodiments, the controller includes a determiner configured to determine whether the data for the second region satisfies a predetermined condition, and
the controller delays completion of the drawing on the first region when the determiner determines that the data for the second region satisfies the predetermined condition.

According to some embodiments, the controller corrects the state of the drawer before starting of drawing on the second region, and delays the completion of drawing on the first region when the determiner determines that the data for the second region satisfies the predetermined condition.

According to some embodiments, the determiner determines whether a volume of the data for the second region satisfies the predetermined condition.

According to some embodiments, the determiner determines whether a number of figures included in the data for the second region satisfies the predetermined condition.

According to some embodiments, the determiner determines whether a wait time before the completion of transfer of the data for the second region satisfies the predetermined condition.

According to some embodiments, the controller includes a drawing operation corrector configured to predict drawing operation of the drawer based on the data for the plurality of regions, and correct the drawing operation of the drawer based on a prediction result of the drawing operation, and
the drawing operation corrector predicts the drawing operation of the drawer in consideration of correcting the state of the drawer between the completion of drawing on the first region and the completion of transfer of the data for the second region, or delaying the completion of drawing on the first region to shorten time from the completion of drawing on the first region to the completion of transfer of the data for the second region.

In a further aspect, which may be provided independently, there is provided a drawing method comprising:
transferring, from an operator, a data for irradiating a plurality of regions with a beam of a drawer when a pattern is drawn on the plurality of regions with the beam; and
controlling, by a controller, the drawing on the plurality of regions by the drawer, based on the data for the plurality of regions transferred from the operator, wherein
when performing the drawing on a first region and then the drawing is on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

In another aspect, which may be provided independently, there is provided a method of manufacturing a plate, comprising:
transferring, from an operator, a data for irradiating a plurality of regions with a beam of a drawer when a pattern is drawn on the plurality of regions with the beam;
controlling, by a controller, the drawing on the plurality of regions by the drawer, based on the data for the plurality of regions transferred from the operator; and
manufacturing a plate from a substrate on which the pattern is drawn by the beam, wherein
when performing the drawing on a first region and then the drawing on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

Features of different aspects or embodiments may be combined in any appropriate combination in further embodiments. Apparatus features may be provided as method features and vice versa.

## Claims

1. A drawing apparatus comprising:
a drawer (1) configured to draw a pattern on a plurality of regions with a beam (B);
an operator (2) configured to transfer data for irradiating the plurality of regions with the beam; and
a controller (22) configured to control the drawing on the plurality of regions with the drawer, based on the data for the plurality of regions transferred from the operator, wherein
when performing the drawing on a first region and then the drawing on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

2. The apparatus of Claim 1, wherein the plurality of regions are a plurality of stripes formed by dividing a drawing region in a predetermined direction.

3. The apparatus of Claim 1 or 2, wherein the correction is beam drift correction of the drawer.

4. The apparatus of any preceding claim, wherein the operator generates the data for irradiating the plurality of regions, from data for pattern drawing on the plurality of regions.

5. The apparatus of Claim 4, wherein the data for pattern drawing on the plurality of regions is drawing data, and the data for irradiating the plurality of regions is shot data.

6. The apparatus of any preceding claim, wherein
the controller includes a determiner (22) configured to determine whether the transfer of the data for the second region is incomplete when the drawing on the first region is completed, and
the controller corrects the state of the drawer before the drawing on the second region is started when the determiner determines that the transfer of the data for the second region is incomplete while the drawing on the first region is completed.

7. The apparatus of any of Claims 1 to 5, wherein
the controller includes a determiner (22) configured to determine whether the data for the second region satisfies a predetermined condition, and
the controller corrects the state of the drawer before the drawing on the second region is started when the determiner determines that the data for the second region satisfies the predetermined condition.

8. The apparatus of any of Claims 1 to 5, wherein
the controller includes a determiner (22) configured to determine whether the data for the second region satisfies a predetermined condition, and
the controller delays completion of the drawing on the first region when the determiner determines that the data for the second region satisfies the predetermined condition.

9. The apparatus of Claim 8, wherein the controller corrects the state of the drawer before starting of drawing on the second region, and delays the completion of drawing on the first region when the determiner determines that the data for the second region satisfies the predetermined condition.

10. The apparatus of Claim 7, wherein the determiner determines whether a volume of the data for the second region satisfies the predetermined condition.

11. The apparatus of Claim 7 or 10, wherein the determiner determines whether a number of figures included in the data for the second region satisfies the predetermined condition.

12. The apparatus of Claim 7, 10 or 11, wherein the determiner determines whether a wait time before the completion of transfer of the data for the second region satisfies the predetermined condition.

13. The apparatus of any preceding claim, wherein
the controller includes a drawing operation corrector (22) configured to predict drawing operation of the drawer based on the data for the plurality of regions, and correct the drawing operation of the drawer based on a prediction result of the drawing operation, and
the drawing operation corrector predicts the drawing operation of the drawer in consideration of correcting the state of the drawer between the completion of drawing on the first region and the completion of transfer of the data for the second region, or delaying the completion of drawing on the first region to shorten time from the completion of drawing on the first region to the completion of transfer of the data for the second region.

14. A drawing method comprising:
transferring, from an operator (2), data for irradiating a plurality of regions with a beam of a drawer (1) when a pattern is drawn on the plurality of regions with the beam (B); and
controlling, by a controller (22), the drawing on the plurality of regions by the drawer, based on the data for the plurality of regions transferred from the operator, wherein
when performing the drawing on a first region and then the drawing is on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.

15. A method of manufacturing a plate, comprising:
transferring, from an operator (2), data for irradiating a plurality of regions with a beam of a drawer (1) when a pattern is drawn on the plurality of regions with the beam (B);
controlling, by a controller, the drawing on the plurality of regions by the drawer (22), based on the data for the plurality of regions transferred from the operator; and
manufacturing a plate from a substrate (S) on which the pattern is drawn by the beam, wherein
when performing the drawing on a first region and then the drawing on a second region, the controller corrects a state of the drawer between completion of drawing on the first region and completion of transfer of the data for the second region or the controller delays the completion of drawing on the first region to shorten time from the completion of drawing on the first region to the completion of transfer of the data for the second region.
